Europäisches Patentamt

(19) European Patent Office

Office européen des brevets

(11) Publication number: **0 013 104**
**B1**

(12) EUROPEAN PATENT SPECIFICATION

(45) Date of publication of patent specification: 15.05.85

(21) Application number: 79302897.8

(22) Date of filing: 14.12.79

(51) Int. Cl.⁴: **G 01 R 31/08**

(54) Fault distance locator.

(30) Priority: 28.12.78 ZA 787333

(43) Date of publication of application:
09.07.80 Bulletin 80/14

(45) Publication of the grant of the patent:
15.05.85 Bulletin 85/20

(84) Designated Contracting States:
AT BE CH DE FR GB IT LU NL SE

(56) References cited:
FR-A-2 057 232
US-A-3 281 673
US-A-3 593 124
US-A-3 800 215

(73) Proprietor: **Electrical Protection Company (PTY)
Limited
Corner Van Dyk and Brakpan Roads
Boksburg, Transvaal (ZA)**

(72) Inventor: **Purton, Alan Lyle
9 Risdon Close
Sturry Kent (GB)**
Inventor: **van Niekerk, Johannes Zacharias
117 Edward Street
Witfield Boksburg (ZA)**

(74) Representative: **Saunders, Harry et al
SAUNDERS & DOLLEYMORE 2 Norfolk Road
Rickmansworth Hertfordshire WD3 1JH (GB)**

**The file contains technical information
submitted after the application was filed and
not included in this specification**

Courier Press, Leamington Spa, England.

## Description

This invention lies in the field of fault location apparatus for determining the distance of a fault on a power supply line, for example from a sub-station, in the context, for example, of electrical power supply systems.

The basic principle of fault location comprises measurement of the voltage and current magnitudes, obtaining a quotient of the voltage over the current to give impedance and with a known impedance-per-unit-distance of a transmission line the distance to the fault from a measuring position can in principle be computed. The practical application of this simple principle in power transmission lines is subject to difficulties arising, for example, due to phase angle effects, earth fault impedance effects in the case of earth faults, and transient effects. Certain fault locators known to applicant are designed to attempt to detect, measure and compensate for these effects; these fault locators become very complex and as a result their main limitation is that they are very costly. An example is a Schlumberger type DCDS 1000 fault locator, and a Schlumberger circuit can be seen described in U.K. Patent 1 415 695. Costliness is a serious disadvantage because it dictates restricted application of the devices and so limited usefulness in a power supply system.

In other fault locators the device inherently is able to provide a record only of the most recent fault (i.e. there is no memory), the record of previous faults to which the device responded being over-ridden by the latest fault information, so that the device is of limited usefulness when installed in unmanned substations. For example, in the case of overhead power transmission lines one or more of the phases of a given line can be subject to numerous faults over a period of time and accordingly information as to fault history can be a valuable aid in diagnosing the cause of the fault.

U.K. Patent 1 355 089, granted to Siemens Akt., describes analogue conversion of AC current and voltage signals derived from the protected lines to proportional DC voltages. However, these DC voltages are then immediately converted to frequencies by voltage-frequency converters after which the said quotient is obtained digitally and further complex computations made to derive a measure of fault distance.

US Patent Specification No. 3,593,124 discloses a method of detecting faults in a polyphase transmission line system. In particular where faults occur between phases a line correction factor is applied in compensation.

French Patent Specification No. 2,057,232 discloses a line fault distance locator. The locator has conversion means which provide DC signals having magnitudes which are proportional to the AC values of current and voltage during a fault condition. Computing means are provided for computing the quotient of the DC signals by dividing the DC signal proportional to the fault voltage by the DC signal proportional to the fault current.

The disadvantage of this arrangement is that the conversion means are responsive to the instantaneous values of current and voltage. This places considerable demands on the instrumentation used to achieve an accurate measurement in a very small period of time. Hence inherently right from the very first measurement step, the locator is faced with a great difficulty in achieving a good accuracy.

This disadvantage is overcome by the present invention because the present invention is characterised in that the conversion means are adapted to render the magnitudes of the DC signals proportional to RMS values of the AC current and voltage or to average values of the rectified said AC current and voltage over a predetermined time interval from inception of the fault, whereby to minimise the influence of transient effects, and that the computing means is adapted to perform an analogue division of the one DC signal by the other, and to apply to a signal representative of the resulting quotient a predetermined line angle correction factor.

Fault locators according to the present invention have inherent in them a considerable simplification as compared with the devices of art, allowing cost reduction by, for example, a decimal order of magnitude. In pursuing such a cost reduction the present new approach has been evolved, as compared with the techniques of the prior art, in that the quotient is derived with DC (i.e. analogue) values and the compensation and correction factors are applied on the basis of theoretical values, derivable from, for example, calculations of line parameters.

A further preferred feature of this invention is that there is incorporated means adapted to detect the level of fault current and activate the fault locator upon a threshold fault current level being exceeded.

This has the advantage that where, as is usually the case, the fault locator is adapted for line fault location on a three phase system, only one said conversion means is required instead of three, the means adapted to detect the level of fault current comprising three fault level detectors, one for each phase, and the outputs of the three detectors being electrically connected in parallel to the single conversion means adapted to provide a DC signal whose magnitude is proportional to the AC value of the greatest of the currents in the respective phases. Thus one can provide a single set of processing components from the divider component to the final print-out for all three phases, thereby economising in apparatus.

Preferably the computing means is adapted to convert said signal representative of said quotient of the DC signals to a binary digital form, so as to provide said measure of distance in this form, preferably after said correction and compensation factors have been applied and the sample-and-hold function has been exercised.

A further preferred characteristic of the fault locator provided by the present invention is a memory element capable of retaining a record of all faults over a period of time, and this can for example be incorporated in a print-out record of the faults, which is moreover preferably co-ordinated with a date and time record, so that the fault history is automatically recorded. In this way the incidence, location, date and time of fault over a period can be recorded by the device and inspected for example at periodic or ad hoc visits to unmanned stations.

This invention will be more fully described by way of example with reference to the accompanying drawings in which:

Figure 1 is a schematic illustration showing the placing of a fault locator in accordance with the preferred embodiment of the invention, in the context of an overhead 3 phase AC power transmission line,

Figure 2 is an X − R diagram, and

Figure 3 is a circuit diagram of the fault locator in accordance with the preferred embodiment of the invention.

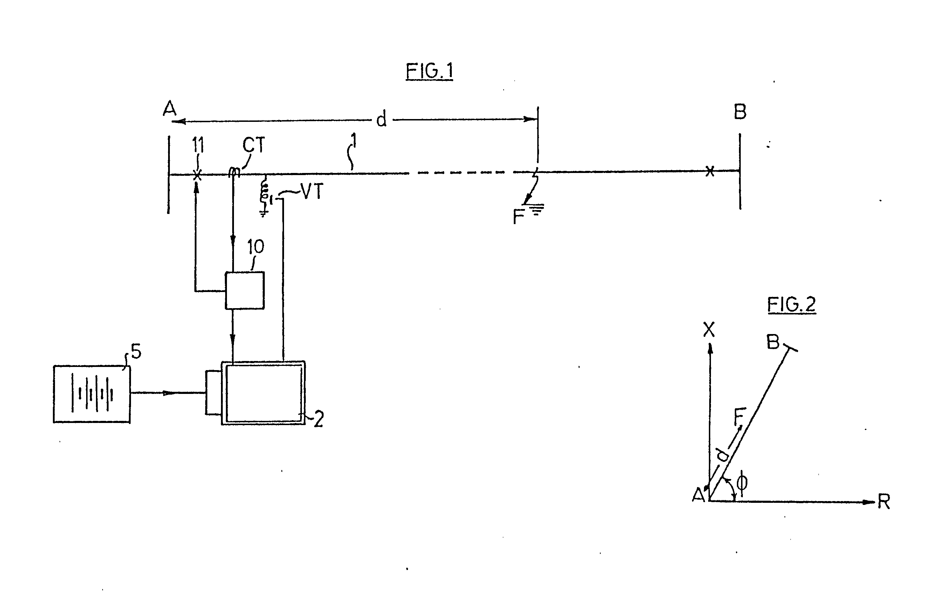

The power transmission system which is represented in Figure 1 consists of a three-phase overhead transmission line 1 of, for example, 160 kilometres in length operating at 275 kilovolts and carrying under normal load conditions 2000 amp per phase. The fault locator 2 is placed in the sub-station at A, drawing its signals from the existing current transformers CT and voltage transformers VT on each of the three phases. An earth fault F is indicated.

The locator draws its power from a 220 volt or 110 volt DC battery 5 which already exists in the sub-station to supply other devices.

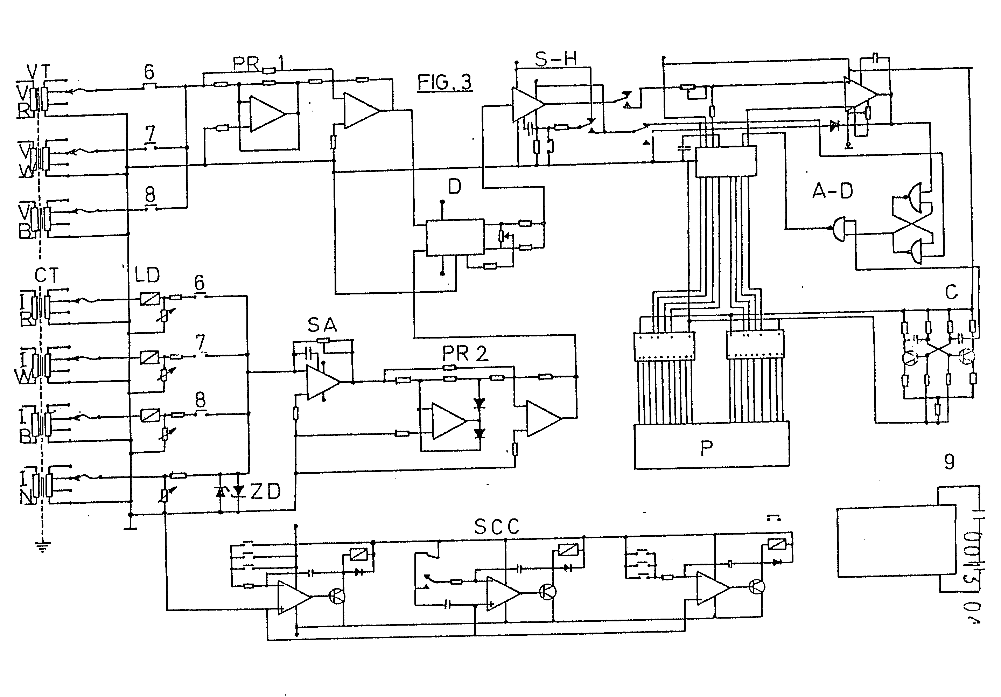

The fault locator, as shown in Figure 3, receives its input signals from the voltage transformers and current transformers on the power lines, which transformers are not shown here in Figure 3. At an input or preliminary stage voltage transformers VR, VW and VB and current transformers IR, IW, IB and IN transform the AC input signal in each case to a low level AC signal.

At a first stage of the fault indicator, which also includes limiters ZD, the level detectors LD, which are preferably transistorised devices (although they could be electro-mechanical devices), are set to close the circuit at 6, 7 or 8 on both the voltage transformer side VT and the current transformer side CT as soon as a predetermined current threshold is exceeded, which threshold is set to correspond to a fault condition.

The AC voltage and current signals are thereupon supplied to a second stage comprising the AC (RMS) to DC converters or precision rectifiers PR1 and PR2 which serve as a conversion means to provide DC signals whose magnitudes are proportional to the AC values of the signals from the voltage and current transformers respectively. (In the case of the AC signal from current transformer CT a summing amplifier SA is interposed to summate the neutral and phase current signals.)

In a third stage the DC signals from the precision rectifiers PR1 and PR2 (being the DC signals proportional respectively to fault voltage and fault current), are fed to the divider D to provide a DC signal representative of said quotient and hence of impedance Z of the fault circuit. At this third stage the earth fault compensation factor Ko and the line angle correction factor φ are applied to said DC quotient signal produced in the divider D. These factors can be applied by potentiometrically biasing the divider output in the manner indicated in Figure 3.

The corrected/compensated impedance signal from the third stage is passed to a fourth stage, the sample-and-hold circuitry S-H, to provide a signal suitable for processing by the analogue to digital convertor A-D. This convertor provides a binary coded decimal output to a printer P. The A-D convertor receives an input from a clock C so as to provide a suitable time base for the conversion.

Sequence control circuits SCC, which are started by the level detectors, control the sample-and-hold circuit and the printer initiation.

A DC power supply to the fault locator circuitry is indicated at 9. The voltage transformer VT in this example provides an output to the locator of 110/63.5 volts, but the locator is adapted to be adjusted so as to accept varying secondary voltage transformer outputs, for example between 63.5 and 220 volts. The device is also adaptable for use with 50 or 60 HZ systems. Substantial insulation and interference protection for the device, having regard to the very hostile environment of its application, will be required.

The device is preferably constructed in a modular fashion using a slide-in card construction in a rack.

A small skeleton printer assembly for the print-out will be employed, for example as has been used in desk type calculators. A variable gain can be provided for the divider circuit to compensate for AC input errors in the AC transformation. The accuracy of the various units, for example the sample-and-hold circuitry, and analogue to digital convertor, is to be of the order of 10 times or greater than the final required accuracy of the device as a whole.

The in-built pick-up time of the level detectors will be used to give the necessary delay at the start of the fault so that fault conditions are measured after transient conditions have substantially subsided.

In the typical example of application shown in Figure 1, the protective relay 10 will have an operating pick-up time of about 40 milli-seconds and will actuate the circuit breaker 11, which having a breaker tripping time of approximately 60 milli-seconds provides approximately 100 milli-seconds for the fault locator to measure the fault circuit characteristics from which the fault distance will be computed. The sample-and-hold component of the device will hold the computed fault distance for approximately 250 milli-seconds so as to facilitate processing by the subsequent components A-D and printer. The device should, however, be able to operate with an even shorter available time such as a total of 60 milli-seconds.

To achieve this, the device could be speeded up by employment of such relays as reed relays for a high speed version. Naturally the transformers must meet the necessary specifications regarding saturation, transient response, accuracy and insulation.

Having regard to the fact that, as in this example the automatic reclose time or turn-about time of the circuit breaker 11 (Figure 1), can seldom be shorter than 350 milli-seconds, and will in many applications often be set at a period of approximately three seconds, the total time required for the fault locator to print out its results could conveniently be set at not more than 800 milli-seconds. The analogue to digital convertor can also be adapted to incorporate a function whereby the signal given, and which is printed out by the printer, is directly the true distance in kilometres. Thus, for example, in the case of Figure 1, the 160 kilometre line may have a typical impedance of approximately 0.31 ohms per kilometre giving a total of 50 ohms impedance for the line. Referring to the representation in Figure 2 of resistance against reactive impedance, the line impedance can be represented by the line A—B indicating the length of the line to suitable scales. Thus, if, for example, the fault impedance duly corrected is 25 ohms, this can easily be calibrated to give a direct read-out of 50% of the total line distance of 160 kilometres, namely 80 kilometres.

Figure 2 also gives an indication graphically of the line angle $\phi$ which relates to the line impedance A—B. A said DC quotient signal arising from a typical earth fault occurring at position F, when appropriately corrected by the earth fault compensation factor Ko for that particular line (which is applied in the device at the divider stage), will give the true distance 'd' of the fault location on the total line length A—B.

A low DC burden on the battery power supply, especially when the device is not in operation, is highly desirable.

The said first stage current transformer CT will be constructed so as to give linear outputs up to 10 or even 50A, and their secondary circuits will be made variable so as to give a voltage proportional to the maximum expected fault current.

The voltage transformers VT will be variable in the same ratio so as to keep the computed impedance value constant.

In the said second stage the level detector can be provided by basic transistor level triggering and a three range selector switch having high, medium and low settings at for example 1 amp, 3 amps and 5 amps; the relay contact output would lead to the divider and subsequent monitor circuits and could also control the measuring time of the unit by having a drop off time of say 50 milliseconds.

The said third stage will extract the DC values from the VT and CT circuits, in the case of the current circuit via a summing circuit for adding phase and neutral currents.

In the said third stage the voltage over amperage divider can be given a gain of from 1 to 10.

The earth fault compensation factor Ko can be made variable from 0.33 to 1.3 and the line angle compensation factor $\phi$ can be made variable from 0.6 to 0.98 by simply having the output DC level of the divider potentiometrically controlled in the manner indicated in Figure 3. It is important to note that by virtue of the basic features of this circuit no compensation of AC signals is required.

In the said fourth stage, the sample-and-hold component, one may use a commercially available integrated circuit sample having a specification as follows:

Acquisition time 1 ms to within 0.1% of its final value;

Accuracy 0.1%;

Discharge rate 1 mV/Sec.

In the said fifth stage, the analogue to digital convertor, one could use a 2.5 or 3.5 digit binary coded decimal chip having a specification as follows:

Accuracy $\pm 0.1\%$ of L.S.B. (least significant bit);

Conversion time $\pm 5$ mS.

In the said sixth stage, the internal clock, free-running with gated output, could be a typical TTL crystal clock whose binary output feeds the printer on command.

In the said seventh stage the printer unit could be a skeleton printer frame fed from the analogue to digital convertor and from the clock with a 0.5 second delayed start command and normal TTL logic input.

The power supply unit 9 must be provided with the necessary insulation and isolation requirements.

The embodiment shown in Figure 3 is for earth fault distance location. An alternative embodiment of the invention can be adapted for locating phase to phase faults. Application of an earth fault compensation factor is not needed for phase to phase faults.

**Claims**

1. A power line fault locator having conversion means (PR) adapted to provide DC signals whose respective magnitudes are proportional to the respective AC values of current and voltage related to a fault and computing means (D) adapted to compute the quotient of signals representative of the voltage and current signals related to the fault, and to provide a measure of the distance (d) to the fault position from a measuring position characterised in that the conversion means are adapted to render the magnitudes of the DC signals proportional to RMS values of the AC current and voltage or to average values of the rectified said AC current and voltage over a predetermined time interval from inception of the fault, whereby to minimise the influence of transient effects, and that the computing means (D) is adapted to perform an analogue division of the one DC signal by the other, and to apply to a signal representative of the resulting quotient a predetermined line angle correction factor.

2. A fault locator as claimed in Claim 1, characterised in that the computing means includes sample and hold means (S-H) which samples and retains finally the quotient of the DC signals at the end of the time interval during which time interval transient effects may subside to some extent.

3. A fault locator as claimed in either one of Claims 1 or 2, characterised in that the computing means (D) is adapted to also apply to said signal representative of said quotient an earth fault compensation factor derived from calculations of line parameters, thereby to provide at its output in respect of an earth fault a measure of the distance (d) to the earth fault position from said measuring position.

4. A fault locator as claimed in any one of Claims 1 to 3, characterised in that the computing means (D) is adapted to apply the line angle correction factor and the optional earth fault compensation factor in DC form by potentiometrically biasing a divider output.

5. A fault locator as claimed in any one of Claims 2 to 4, characterised by a detector (LD) adapted to detect the level of fault current and activate the fault distance locator upon a predetermined threshold fault current level being exceeded.

6. A fault locator as claimed in Claim 5, which is adapted for fault location on a three phase power line system, characterised in that the detector (LD) comprises three fault current level detectors, one for each phase, the outputs of the three detectors being electrically connected in parallel to a single conversion means adapted to provide a DC signal whose magnitude is proportional to the RMS value of the greatest of the AC currents in the respective phases.

7. A fault locator as claimed in any one of Claims 2 to 6, characterised in that the computing means (D) further comprises analogue to digital convertor means (A-D) which is adapted to convert said signal representative of said quotient of the DC signals to a binary digital form, so as to provide said measure of distance in this form.

8. A fault locator as claimed in Claim 7, characterised by a printer (P) to which each successive signal in binary digital form is supplied together with a time signal, and of which the printed output constitutes a printed history of faults and their respective times and dates of occurrence.

**Patentansprüche**

1. Störungsortungsgerät für Starkstromleitungen mit Wandlereinrichtungen (PR), die zur Schaffung von Gleichstromsignalen eingerichtet sind, deren jeweilige Grösse den jeweiligen Wechselstromwerten von Strom und Spannung einer Störung proportional sind und Recheneinrichtung (D) eingerichtet zur Errechnung des Quotienten von die Spannungs- und Stromsignale für den Fehler darstellenden Signalen und eine die Entfernung (D) der Fehlerstelle in Bezug auf eine Messtelle bestimmende Grösse zu liefern, dadurch gekennzeichnet dass die Wandlereinrichtungen dazu eingerichtet sind, die Stärken der Gleichstromsignale proportional zu den quadratischen Mittelwerten der Wechselstromstärke und Wechselstromspannung bzw. der Durchschnittswerte der betreffenden gleichgerichteten Wechselstromstärke und Spannung für eine festgelegte Zeitdauer vom Eintreten der Störung einzustellen, und dadurch den Einfluss von Einschwingwirkungen zu beschränken, und dass die Rechnereinrichtungen (D) dazu eingerichtet sind, eine Analogdivision des einen Gleichstromsignals durch das andere Gleichstromsignal durchzuführen und auf ein den sich daraus ergebenen Quotienten darstellendes Signal einen festgelegten Leitungswinkelberichtigungsfaktor anzuwenden.

2. Störungsortungsgerät gemäss Anspruch 1, dadurch gekennzeichnet, dass das Rechnerteil eine Abfrage-und-Halteeinrichtung (S-H) besitzt, welche letzten Endes den Quotienten der Gleichstromsignale am Ende der Zeitspanne während welcher Einschwingungswirkungen weitgehend abklingen, abfrägt und hält.

3. Störungsortungsgerät gemäss einem der Ansprüche 1 oder 2, dadurch gekennzeichnet, dass die Rechnereinrichtung (D) auch dazu eingerichtet ist, auf den genannten Quotienten einen Erdfehlerkompensationsfaktor aufzutragen, abgeleitet aus Berechnungen der Leitungskenndaten, um dadurch an seinem Ausgang hinsichtlich eines Erdfehlers eine Grösse für den Abstand (d) von der Messtelle bis zur Erdfehlerstelle zu liefern.

4. Störungsortungsgerät gemäss einem der Ansprüche 1 bis 3, dadurch gekennzeichnet, dass die Rechnereinrichtung (D) dazu eingerichtet ist, den Leitungswinkelberichtigungsfaktor und gegebenenfalls den Erdfehlerkompensationsfaktor in Gleichstromform durch potentiometrische Verbeaufschlagung eines Teilerausgangs anzuwenden.

5. Störungsortungsgerät gemäss einem der Ansprüche 2 bis 4, gekennzeichnet durch einen Detektor (LD), der dazu eingerichtet ist, die Grösse des Fehlerstromes festzustellen und nach Überschreitung eines festgelegten Fehlerstromgrenzwertes das Störungsortungsgerät zu aktivieren.

6. Störungsortungsgerät gemäss Anspruch 5, eingerichtet zur Störungsortung an einem Drehstromkraftnetz, dadurch gekennzeichnet, dass der Detektor (LD) drei Detektoren zur Wahrnehmung der Störungsströmungsgrösse, einen für jede Phase besitzt, wobei die Ausgänge der drei Detektoren elektrisch parallel zu einer einzigen Wandlereinrichtung geschaltet sind, die dazu eingerichtet ist, ein Gleichstromsignal zu liefern, dessen Grösse dem quadratischen Mittelwert des stärksten Stromes in den betreffenden Phasen proportional ist.

7. Störungsortungsgerät gemäss einem der Ansprüche 2 bis 6, dadurch gekennzeichnet, dass die Rechnereinrichtung (D) ausserdem Analog/digital Wandlereinrichtungen besitzt (A/D) dazu eingerichtet, das den Quotienten der Gleichstromsignale darstellende Signal in eine binäre Digitalform umzuwandeln und somit die Entfernungsgrösse in dieser Form zu liefern.

8. Störungsortungsgerät gemäss Anspruch 7, gekennzeichnet durch ein Schreibergerät (P), dem jedes der aufeinanderfolgenden Signale in binärer Digitalform zugeliefert wird, gemeinsam mit einem Zeitsignal, und von dem das Schreibergebnis eine ausgedruckte historische Darstellung der Störungen und derer jeweiligen Vorkommenszeiten und Daten darstellt.

**Revendications**

1. Dispositif de localisation de la distance d'un défaut sur une ligne d'alimentation électrique comportant des moyens de conversion (PR) adaptés pour fournir des signaux continus dont les amplitudes respectives sont proportionnelles aux valeurs alternatives respectives du courant et de la tension dus à un défaut et des moyens de calcul (D) adaptés de manière à calculer le quotient de signaux représentant la tension et le courant dus au défaut et à fournir une mesure de la distance (d) de l'endroit position du défaut par rapport à l'endroit position où s'effectue la mesure, caractérisé en ce que les moyens de conversion sont adaptés de manière à rendre les amplitudes des signaux continus proportionnelles aux valeurs efficaces du courant et de la tension alternatifs ou aux valeurs moyennes des courants et tensions alternatifs redressés pendant un intervalle de temps prédéterminé à partir de l'apparition du défaut, afin de minimiser l'influence des effets transitoires, et en ce que les moyens de calcul (D) sont adaptés de manière à effectuer une division analogique de l'un des signaux continus par l'autre et à appliquer un facteur prédéterminé de correction d'angle de ligne à un signal représentant le quotient résultant.

2. Dispositif de localisation de défaut suivant la revendication 1 caractérisé en ce que les moyens de calcul comportent un circuit d'échantillonnage et de maintien (S-H) qui échantillonne et conserve finalement le quotient des signaux continus à la fin de l'intervalle de temps pendant lequel les effets transitoires peuvent s'évanouir dans une certaine mesure.

3. Dispositif de localisation de défaut suivant l'une quelconque des revendications 1 ou 2, caractérisé en ce que les moyens de calcul (D) sont adaptés de manière à appliquer également, au signal représentant le quotient, un facteur de compensation de défaut à la terre obtenu à partir de calculs des paramètres de la ligne, de manière à fournir à sa sortie, pour un défaut à la terre donné, une mesure de la distance (d) entre l'endroit où apparaît ce défaut et l'endroit où s'effectue la mesure.

4. Dispositif de localisation de défaut suivant l'une quelconque des revendications précédentes 1 à 3 caractérisé en ce que les moyens de calcul (D) sont adaptés de manière à appliquer le facteur de correction d'angle de ligne et le facteur éventuel de compensation de défaut à la terre sous une forme continue, en polarisant par un potentiomètre une sortie du diviseur.

5. Dispositif de localisation de défaut suivant l'une quelconque des revendications 2 à 4 caractérisé en ce qu'il comprend un détecteur (LP) adapté de manière à détecter le niveau d'un courant de défaut et à mettre en service le dispositif de localisation de défaut lorsqu'un niveau prédéterminé de seuil de courant de défaut est dépassé.

6. Dispositif de localisation de défaut suivant la revendication 5 qui est adapté pour la localisation de défaut dans un système de ligne de transport d'énergie électrique triphasée, caractérisé en ce que le détecteur (LD) comprend trois détecteurs de niveau de courant de défaut à raison d'un pour chaque phase, les sorties de ces trois détecteurs étant connectées électriquement en parallèle à un dispositif de conversion unique adapté de manière à fournir un signal continu dont l'amplitude est proportionnelle à la valeur efficace du plus grand des courants alternatifs dans les phases respectives.

7. Dispositif de localisation de défaut suivant l'une quelconque des revendications 2 à 6 caractérisé en ce que les moyens de calcul (V) comprennent en outre un convertisseur analogique/numérique (A-D) qui est adapté de manière à convertir le signal représentant le quotient des signaux continus sous forme numérique binaire, afin de fournir la mesure de la distance sous cette forme numérique.

8. Dispositif de localisation de défaut suivant la revendication 7 caractérisé en ce qu'il comporte imprimante (P) à laquelle est fourni, conjointement avec un signal d'horloge, chaque signal successif sous forme numérique binaire, la sortie imprimée constituant un historique imprimé des défauts ainsi que des instants et dates respectifs de leur apparition.

FIG.1

FIG.2

0013104

FIG. 3